**Europäisches Patentamt**

(19) **European Patent Office**

**Office européen des brevets**

(11) Veröffentlichungsnummer: **0 157 003**
**B1**

(12) **EUROPÄISCHE PATENTSCHRIFT**

(45) Veröffentlichungstag der Patentschrift:
**23.11.88**

(51) Int. Cl.⁴: **G 01 B 7/08**, G 01 R 29/24

(21) Anmeldenummer: **84116167.2**

(22) Anmeldetag: **22.12.84**

(54) Verfahren zur Messung der Partikelablagerungsmenge auf einem pulverzubeschichtenden Metallkörper, Vorrichtung zur Ausführung des Verfahrens und Verwendung des Verfahrens.

(30) Priorität: **10.02.84 CH 652/84**

(43) Veröffentlichungstag der Anmeldung:
**09.10.85 Patentblatt 85/41**

(45) Bekanntmachung des Hinweises auf die Patenterteilung:
**23.11.88 Patentblatt 88/47**

(84) Benannte Vertragsstaaten:
**AT BE CH DE FR GB IT LI LU NL SE**

(56) Entgegenhaltungen:
**CH-A-529 990**
**GB-A-2 000 990**
**US-A-3 378 676**
**US-A-3 775 277**
**US-A-3 888 207**

**PATENTS ABSTRACTS OF JAPAN, Band 7, Nr. 127**
**(P-201)(1272), Seite 34 P 201; & JP - A - 58 44 361**
**(TOKYO SHIBAURA DENKI K.K.) 15-03-1983**

(73) Patentinhaber: **Präzisions- Werkzeuge AG,**
**Breitenhofstrasse 7, CH- 8630 Rüti (CH)**

(72) Erfinder: **Ribnitz, Peter, Haselstrasse 15, CH- 9013**
**St. Gallen (CH)**

(74) Vertreter: **Troesch, Hans Alfred, Dr. Ing.,**
**Walchestrasse 19, CH- 8035 Zürich (CH)**

## Beschreibung

Die vorliegende Erfindung betrifft ein Verfahren sowie eine Anordnung zur Ablage von Partikeln über einen Metallkörper und zur Messung der abgelegten Partikelmenge, bei dem bzw. der zwischen dem Metallkörper, als eine Elektrode, und einer diesbezüglich auf Abstand gehaltenen Gegenelektrode ein elektrostatisches Feld angelegt wird und sich in einem zwischen den Elektroden gebildeten Feldraum befindende Partikel durch die Kraft des Feldes gegen den Körper getrieben werden, wobei verfahrensmässig aus einer Messung einer in einem die Elektroden verbindenden Stromkreis fliessenden Ladung auf die abgelegte Partikelmenge geschlossen wird und vorrichtungsmässig eine Ladungsmesseinrichtung in einem die Elektroden verbindenden Stromkreis, zur Messung der über dem Metallkörper abgelegten Partikelmenge, vorgesehen ist, sowie Verwendungen davon.

Einerseits sind Ablageverfahren bzw. -anordnungen für Partikel, bei denen zwischen einem Metallkörper, als eine Elektrode, und einer diesbezüglich auf Abstand gehaltenen Gegenelektrode ein elektrostatisches Feld angelegt wird und sich in einem zwischen den Elektroden gebildeten Feldraum befindende Partikel durch die Kraft des Feldes gegen den Körper getrieben werden, beispielsweise aus der US-A-3 888 207 und aus der GB-A-2 000 990 bekannt.

Anderseits sind zur Messung der über einem Metallkörper abgelegten Partikelmenge verschiedene Verfahren bekannt. So schlägt die US-PS-3 378 676 vor, aus einer Messung vor Ablage der Partikel sowie einer Messung darnach auf die abgelegte Partikelmenge zu schliessen. Die US-A-3 775 277 schlägt dazu, bei Kathodenzerstäubung vor, im Plasma einen Detektor vorzusehen, der teilweise wie ein zu beschichtendes Substrat beschichtet wird, und an diesem Detektor, aus einer Spannungsmessung, auf die Änderung der durch die aufgebrachte Schicht sich ändernden Kapazität und daraus dann auf die abgelegte Partikelmenge zu schliessen. Bei einem, wie oben erwähnt, elektrostatisch unterstützten Ablageverfahren, schlägt nun die JP-A-5 844 361 vor, den Metallkörper über eine Kapazität mit Massepotential zu verbinden, um die Menge der durch die Kraft des Feldes gegen den Körper getriebenen Partikel aus Messung der dadurch auf der genannten Kapazität durch Influenz entstehenden Spannung zu erfassen.

Bei diesem letzterwähnten Verfahren ist es nachteilig, dass an einer Kapazität eine Spannungsmessung vorgenommen werden muss, was grundsätzlich zu einer Entladung der genannten Kapazität führt, so dass eine statische Messung problematisch ist. Zudem muss der Metallkörper, auf welchen Partikel, feldgetrieben, abgelegt werden, bezüglich Masse hochisolierend betrieben werden, und in vielen Anwendungsfällen ist es ausserordentlich schwierig, die zwischen dem Metallkörper und Erde auftretende Streukapazität mitzusichtigen.

Aus der CH-PS-529 990 ist nun ein Verfahren sowie eine Anordnung eingangs genannter Gattung bekannt. In einem Metallbehälter, als Metallkörper, ist eine Flüssiglösung mit abzulegenden Partikeln enthalten. Der Metallkörper bildet eine Elektrode, eine Gegenelektrode ist in die Flüssiglösung eingetaucht. Zwischen beiden Elektroden wird mittels einer stabilisierten Spannungsquelle ein elektrostatisches Feld angelegt. Damit werden die sich im zwischen den Elektroden gebildeten Feldraum in Lösung befindenden Partikel durch die Kraft des Feldes gegen den Körper getrieben. In einem die Elektroden verbindenden Stromkreis wird, nach abgeschlossener Beschichtung, d.h. Abtrennung der Spannungsquelle, aus der Registrierung eines Entladevorganges der durch die Partikelablage gebildeten Kapazität - Lösung/abgelegte Partikelschicht/Metallkörper - auf die Schichtdicke geschlossen, wobei die über dieser Schicht liegende Spannung bekannt ist und die Schichtkapazität ermittelt wird.

Dabei wird auch während des Ablagevorganges die im genannten Stromkreis fliessende Ladung durch Integration ermittelt. Da aber die Anordnung der beiden Elektroden und der sich aufbauenden Schicht am Metallkörper sowie der Lösung, als Serieschaltung eines Widerstandes - entsprechend der Lösungsleitfähigkeit - und einer zeitvariablen Kapazität - entsprechend der sich aufbauenden Schicht - betrachtet werden kann, ist diese Ladungsmessung vornehmlich für die Zeitvarianz der sich aufbauenden Schichtkapazität repräsentativ. Somit ist dieses bekannte Vorgehen dahingehend nachteilig, dass erstens nach dem Ablagevorgang und zweitens nur die abgelegte Gesamtpartikelmenge gemessen werden kann.

Die vorliegende Erfindung setzt sich zum Ziel, das genannte Vorgehen so weiterzubilden, dass Information über die pro Zeiteinheit abgelegte Partikelmenge erhalten wird.

Zu diesem Zweck zeichnet sich das erfindungsgemässe Verfahren nach dem Wortlaut von Anspruch 1, die erfindungsgemässe Anordnung nach dem Wortlaut von Anspruch 5 aus.

Dadurch, dass Messignal der während des Ablagevorganges pro Zeiteinheit abgelegten Partikelmenge entspricht, ergibt sich die Möglichkeit, das Messignal als gemessene Regelgrösse in einem Regelkreis zur Führung der Ablagerungsmenge pro Zeiteinheit, als Regelgrösse, einzusetzen und damit beispielsweise im Durchlaufbetrieb die abgelegte Partikelmenge bzw. Schichtdicke in engen Toleranzen zu regeln. Als Stellgrösse im Regelkreis wird dabei die pro Zeiteinheit in den Feldraum eingebrachte Partikelmenge und/oder die zwischen den Elektroden aufgebrachte Feldstärke und/oder die Aufladung der Partikel vor Eintreten in den Feldraum eingesetzt. Letzteres wird dadurch erreicht, dass, in Anlehnung an die Aufladungstechnik bei Rauchdetektoren, die Partikel vor Eintreten in den Feldraum, beispielsweise durch eine radioaktive Quelle, mit entsprechender Polarität aufgeladen werden.

Das genannte Verfahren sowie die genannte Anordnung eignen sich insbesondere für den Einsatz an im Durchlaufbetrieb zu beschichtenden Metallkörpern, dabei insbesondere für die Durchlaufbeschichtung von Schweissnähten an Metalldosenkörpern.

Die Erfindung wird anschliessend beispielsweise anhand von Figuren erläutert.

Es zeigen:

Fig. 1 eine schematische Anordnung einer elektrostatischen Pulverbeschichtungsvorrichtung, zur Erläuterung des erfindungsgemässen Verfahrens,

Fig. 2 die erfindungsgemässe Anordnung einer Ladungsmessvorrichtung an der Anordnung gemäss Fig. 1, zur Erfassung der Pulverablagerungs-Gesamtmenge,

Fig. 3 ein Funktionsblockdiagramm einer erfindungsgemässen Vorrichtung zur Messung der pro Zeiteinheit auf einen zu beschichtenden Körper aufgebrachten Pulvermenge und zur Regelung der Pulverschichtdicke am bewegten Körper,

Fig. 4 eine bevorzugte Ausführungsform einer erfindungsgemässen Schichtdickenregelung für die Innenbeschichtung von Schweissnähten an Blechdosenkörpern.

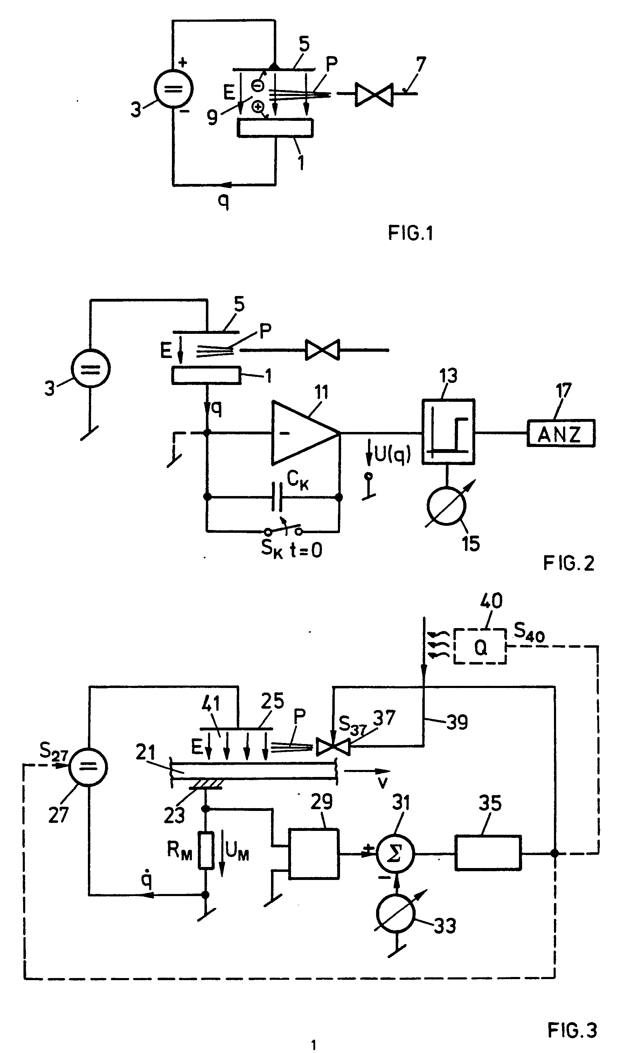

Gemäss Fig. 1 wird ein zu beschichtender Körper 1 über eine Gleichspannungsquelle 3, die eine Spannung in der Grössenordnung von 70 kV abgibt, mit einer Gegenelektrode 5 verbunden. Dabei wirkt der metallische Körper 1 als die eine Elektrode. Über eine schematisch dargestellte Zuführleitung 7 und eine Düse wird Pulver P in den vom Feld E erfüllten Raum 9 zwischen Körper 1 und Elektrode 5 eingespritzt. Primär wegen der hohen Feldstärke E im zwischen Elektrode 5 und Körper 1 definierten Feldraum 9 wird das Pulver P aufgeladen und entsprechend der Ladungspolarität auf den Körper 1 abgelagert resp. auf der Gegenelektrode 5. Dabei bewirkt die durch geladene Pulverpartikel erfolgende Ladungsverschiebung im Feldraum 9 eine Ladungsverschiebung in dem die beiden Elektroden, d.h. Körper 1 und Gegenelektrode 5, verbindenden Stromkreis über die Spannungsquelle 3. Es wird nun diese Ladungsverschiebung im die Elektroden verbindenden Stromkreis zur Erfassung der Pulverablagerungsmenge auf dem Körper 1 gemessen.

In Fig. 2 ist eine prinzipielle Schaltungsanordnung dargestellt, mit deren Hilfe die Ladungsverschiebung q entsprechend der gesamten abgelagerten Pulvermenge erfasst wird. Hierzu ist grundsätzlich in dem den Körper 1 als eine Elektrode und die Gegenelektrode 5 gemäss Fig. 1 verbindenden Stromkreis eine Ladungsmessvorrichtung angeordnet. Gemäss Fig. 2 ist hierzu der Körper 1 als die eine Elektrode des durch ihn und die Gegenelektrode 5 gebildeten Kondensatore, auf den Eingang eines mit der Rückkopplungskapazität $C_K$ als Ladungsverstärker geschalteten Operationsverstärkers 11 geführt. Durch den Operationsverstärker 11 in invertierender Schaltungskonfiguration wird der Körper 1 auf Erdpotential gelegt, ebenso ist der eine Anschluss der Spannungsquelle 3 auf Erde geschaltet. Die Gegenkopplungskapazität $C_K$ des Ladungsverstärkers ist mittels eines Schalters $S_K$ rücksetzbar. Wird bei geschlossenem Schalter $S_K$ die Gleichspannungsquelle 3 über die durch Elektrode 5 und Körper 1 gebildete Kapazität aufgeschaltet, dann der Schalter $S_K$ geöffnet, so misst der Ladungsverstärker ab diesem Zeitpunkt die im Kreis 3, 5, 1 fliessende Ladung q. Das Ausgangssignal U(q) des Ladungsverstärkers ist ein Mass für die ab besagtem Zeitpunkt erfolgte Ladungsverschiebung q, welche ihrerseits ein Mass für die ab diesem Zeitpunkt auf den Körper 1 abgelagerte Pulvermenge ist. Aus der zeitlichen Ableitung des Ausgangssignals U(q), d.h. dessen Steigung, kann auf den zeitlichen Aufbau der Pulverablagerung geschlossen werden. Wird das Ausgangssignal U(q) des Ladungsverstärkers einer Komparatorschaltung 13 zugeführt, mit an einer Referenzspannungsquelle 15 einstellbarem Schwellwert, so ergibt sich am Ausgang des Komparators 13 ein Anzeigesignal für eine Anzeige 17, sobald das Ausgangssignal des Ladungsverstärkers 11 den Referenzwert erreicht, d.h. sobald eine bestimmte Schichtdicke am Körper 1 abgelagert ist. Mit dieser Anordnung lässt sich an einem stationär angeordneten Körper 1 überwachen, ob eine SOLL-Schichtdicke abgelagert worden ist. In vielen Anwendungsfällen wird das Pulverbeschichtungsverfahren an einem kontinuierlich durchlaufenden Körper vorgenommen. Die Schichtdicke am durchlaufenden Körper ergibt sich dann bei Kenntnis seiner Durchlaufgeschwindigkeit durch den feldbeaufschlagten Raum, aus der Partikelablagerung pro Zeiteinheit, was die Messung der elektrischen Ladungsverschiebung pro Zeiteinheit $\dot{q}$ im Stromkreis zwischen den obgenannten Elektroden zur Überwachung nötig macht.

Gemäss Fig. 3 wird ein zu beschichtender Körper 21, beispielsweise mittels Schleifkontakten oder Bürsten elektrisch kontaktiert. Eine Gleichspannungsquelle 27, die eine hohe Gleichspannung abgibt, ist grundsätzlich einerseits mit der Elektrode 25 verbunden, anderseits über den Schleifkontakt 23 mit dem als Gegenelektrode wirkenden, bewegten Körper 21. Soll nun die Ladungsverschiebung pro Zeiteinheit $\dot{q}$ in dem zwischen dem Körper 21 als eine Elektrode und der Elektrode 25 bestehenden Stromkreis gemessen werden, so kommt dies einer Strommessung gleich. Um den Strom zu messen, ist zwischen dem Kontakt 23 zum Körper 21 und Bezugspotential ein Messwiderstand $R_M$ geschaltet, dessen Spannung mittels einer Spannungsmessvorrichtung 29 abgegriffen wird. Das der Spannung $U_M$ über dem Messwiderstand $R_M$ entsprechende Ausgangssignal der Spannungsmessvorrichtung 29, beispielsweise eines Operationsverstärkers in Folgerschaltung, wird nun als gemessene Regelgrösse einer Differenzeinheit 31 zugeführt, an deren zweitem Eingang eine vorzugsweise einstellbare Führungssignalquelle 33 zugeschaltet ist. Das der Differenz zwischen gemessener Regelgrösse und Führungsgrösse entsprechende Regeldifferenz-Ausgangssignal der Differenzeinheit 31 wird vorzugsweise über einer Regler 35, auf einen Steuereingang $S_{37}$ einer einstellbaren Düse 37 aufgeschaltet, welche in der Zuführleitung 39 für die Pulverzuführung in den Feldraum 41 zwischen Elektrode 25 und Körper 21 vorgesehen ist. Durch Stellen der steuerbaren Düse 37 als Stellglied im Regelkreis wird die pro Zeiteinheit in den Feldraum 41 eingespritzte Pulvermenge so gestellt, dass der Strom durch den Messwiderstand $R_M$ dem Führungssignal entspricht und somit die pro Zeiteinheit auf dem Körper 21 abgelagerte Pulvermenge. Bewirken Störeinflüsse, wie beispielsweise und insbesondere eine durch Ablagerung entsprechend geladener Pulverpartikel bewirkte Verkrustung der Elektrode 25 eine z. B. Ablagerungsmengenabnahme, so regelt dann der Regelkreis durch Erhöhung der pro Zeiteinheit dem Feldraum 41 zugeführten Pulvermenge diesen Störeinfluss aus. Obwohl der Einsatz der steuerbaren Düse 37 als Stellglied bevorzugt wird, ist es auch, wie gestrichelt angedeutet, möglich, die Gleichspannungsquelle 27 dann mit einem Steuereingang $S_{27}$ versehen, als Stellglied zu verwenden. Durch entsprechende Verstellung der felderzeugenden Spannung der Quelle 27 wird ebenfalls die pro Zeiteinheit auf den Körper 21 abgelagerte Pulvermenge verstellt. Der bis anhin erfolgten Beschreibung lag die Annahme zugrunde, dass das in den Feldraum, beispielsweise 41 von Fig. 3 eingespritzte Pulver primär durch Wirkung des hohen elektrostatischen Feldes, wie durch Ionisierungserscheinungen geladen wird. Das Pulver kann jedoch bereits vor Einschiessen in den Feldraum 41 aufgeladen werden, wie dies beispielsweise bei Rauchdetektoren bekannt ist, wo Rauchgas mit radioaktiven Quellen aufgeladen wird. Ist es, wie ebenfalls in Fig. 3 gestrichelt angedeutet, vorgesehen, die Pulverpartikel auf diese Art und Weise mit einer Strahlungsquelle 40, bereits vor dessen Eintreten in den Feldraum 41 mit vorgegebener Polarität aufzuladen, so kann an einem vorgesehenen Steuereingang $S_{40}$ für die Strahlungsintensität der Quelle 40 eingegriffen werden, und die Strahlungsquelle 40 als Stellglied eingesetzt sein.

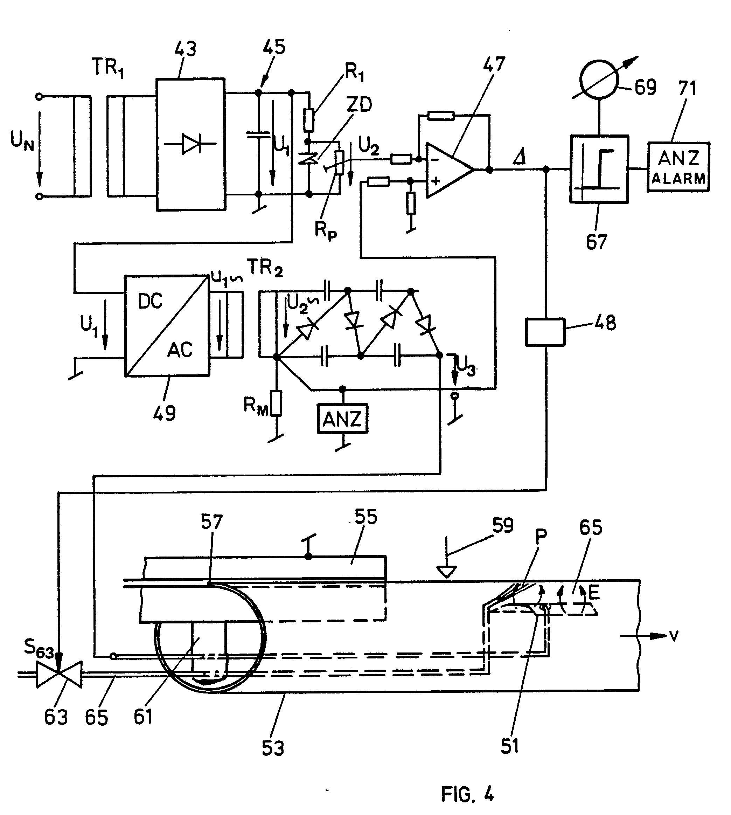

In Fig. 4 ist ein bevorzugtes Ausführungsbeispiel der erfindungsgemässen Vorrichtung für die Schichtdickenregelung bei der Schweissnahtinnenbeschichtung von kontinuierlich hergestellten metallischen Dosenkörpern, wie für die Lebensmittelindustrie dargestellt. Die Netzspannung $U_N$ wird an einem ersten Transformator $TR_1$ mit nachgeschalteter Gleichrichter- und Glättungsschaltung 43, 45 in eine Gleichspannung $U_1$ gewandelt. Ein Teil der Gleichspannung U wird über eine Zenerdiode ZD mit seriegeschaltetem Widerstand $R_1$ abgegriffen, als nun stabilisierte Spannung $U_2$ und liegt über einem Potentiometer $R_p$. Am Mittenabgriff des Potentiometers $R_p$ abgegriffen, wird ein Teil der stabilisierten Spannung $U_2$ dem einen Eingang eines als Differenzverstärker geschalteten Operationsverstärkers 47 zugeführt. An einem Gleichspannungs/Wechselspannungswandler 49 wird die Gleichspannung $U_1$ ausgangsseitig in eine Wechselspannung $u_1$ gewandelt, die der Primärseite eines Hochspannungstransformators $TR_2$ aufgeschaltet ist. Die Sekundärseite des Hochspannungstransformators $TR_2$ ist einerseits über den Messwiderstand $R_M$ auf Bezugspotential, vorzugsweise Erd-Potential gelegt, die sekundärseitige Spannung $u_2\sim$ wird mit einer bekannten Greinacherschaltung hochtransformiert und als hohe Gleichspannnung $U_3$ auf die eine Elektrode 51 geschaltet. Es soll nun im Durchlaufbetrieb die Längsinnenschweissnaht an einem aus einer erst offenen Blechzarge geformten und dann verschweissten Blechrohrkörper 53 beschichtet werden, zur Herstellung von Metallbüchsen. Nach Durchlaufen einer hier nicht dargestellten Formungsstation wird das noch nicht längsverschweisste Blechrohr 53 einer Führungsvorrichtung 55 zugeführt, beispielsweise einer bekannten Z-Führung, worin die noch offenen Blechränder 57 für die anschliessende Verschweissung bei der nur schematisch eingezeichneten Schweissstation 59 geführt und positioniert werden. Üblicherweise müssen die Ränder 57 für die anschliessende Schweissung in der Z-Führung 55 sehr genau geführt werden, so dass im Führungsbereich eine galvanische Kontaktierung zwischen Z-Führung und Körper 53 meistens bereits ohne zusätzliche Vorkehrungen gewährleistet ist. Allenfalls können aber zur Gewährleistung der galvanischen Verbindung zusätzliche Schleif- resp. Bürstenkontakte vorgesehen sein. Über die Z-Führung 55 wird der gesamte Körper 53 auf Erdpotential als Bezugspotential gelegt. Die Elektrode 51 wird, wie aus Fig. 4 ersichtlich, achsparallel zur Achse des Körpers 53 elektrisch angeschlossen und liegt in einem Bereich, in welchem die bezüglich der Schweißstation 59 aufwärts gelegenen Ränder 57 bereits verschweisst sind. Die Elektrode 51 mit ihrer Zuführung ist, wie mit 61 schematisch dargestellt, mit Bezug auf Körper 53 und Z-Führung 55 elektrisch isoliert. Der Ausgang des Differenzverstärkers 47 ist allenfalls über einen entsprechend dimensionierten Regler 48

auf den Steuereingang $S_{63}$ der steuerbaren Düse 63 in der Zuleitung für das Beschichtungspulver 65 geführt. Die Zuleitung 65 ragt analog zur elektrischen Zuleitung für die Elektrode 51, achsparallel in den Körper 53 ein und spritzt Pulver P in den zwischen Elektrode 51 und Körper 53 gebildeten Feldraum 65. Auf diese Art und Weise wird am Messwiderstand $R_M$ die Spannung U abgegriffen und dem Differenzverstärker 47 entsprechend der Differenzeinheit 31 von Fig. 3 zugeführt. Am Potentiometer $R_p$ entsprechend der Führungssignalquelle 33 von Fig. 3 wird der SOLL-Wert eingegeben und nach Massgabe des Vergleichs von SOLL-Wert und Strom-IST-Wert erscheint am Ausgang des Differenzverstärkers 47 das Regeldifferenzsignal Δ welches auf die Düse 63 als Stellglied wirkt. Kann nun auch mit Vollaussteuerung der Düse 63 als Stellglied, der Strom-IST-Wert, gemessen am Messwiderstand $R_M$, nicht mehr dem am Potentiometer $R_p$ eingestellten SOLL-Wert entsprechend gestellt werden, beispielsweise bei starker Verkrustung der Elektrode 51, so wird die am Ausgang des Differenzverstärkers 47 erscheinende Regeldifferenz Δ anwachsen. Um solche Zustände anzuzeigen, ist der Ausgang des Differenzverstärkers 47 auf eine Komparatorschaltung 67 geführt, dessen Ansprechwert mit einer Referenzsignalquelle 69 einstellbar ist, so dass am Ausgang der Komparatoreinheit 67 ein Anzeigesignal für eine Anzeige und/oder eine Alarmeinrichtung 71 erscheint, wenn die Regeldifferenz am Ausgang des Differenzverstärkers 47 über einem an der Quelle 69 einstellbaren Wert liegt.

## Patentansprüche

1. Verfahren zur Ablage von Partikeln über einen Metallkörper und zur Messung der abgelegten Partikelmenge, bei dem zwischen dem Metallkörper (1; 21; 55), als eine Elektrode, und einer diesbezüglich auf Abstand gehaltenen Gegenelektrode (5; 25; 51) ein elektrostatisches Feld (E) angelegt wird und sich in einem zwischen den Elektroden (1, 5; 21, 25; 51, 55) gebildeten Feldraum befindende Partikel (P) durch die Kraft des Feldes gegen den Körper (1; 21; 55) getrieben werden und aus einer Messung einer in einem die Elektroden verbindenden Stromkreis (3; 3, 11; $R_M$, 29; $R_M$, 47) fliessenden Ladung auf die abgelegte Partikelmenge geschlossen wird, dadurch gekennzeichnet, dass ein Partikelstrom in einen luftgefüllten Feldraum eingebracht wird und dabei die pro Zeiteinheit abgelegte Menge durch Messung der pro Zeiteinheit im Stromkreis fliessenden Ladung (q) erfasst wird.

2. Verfahren nach Anspruch 1, dadurch gekennzeichnet, dass die während einer vorgegebenen Zeitspanne abgelegte Partikelmenge durch Integrierung der gemessenen Ladung erfasst wird.

3. Verfahren nach Anspruch 1 oder 2, dadurch gekennzeichnet, dass das Messignal als gemessene Regelgrösse in einem Regelkreis (31, 35, 37) zur Führung der Ablagerungsmenge pro Zeiteinheit, als Regelgrösse, eingesetzt wird.

4. Verfahren nach Anspruch 3, dadurch gekennzeichnet, dass als Stellgrösse im Regelkreis die pro Zeiteinheit in den Feldraum eingebrachte Partikelmenge (P) und/oder die zwischen den Elektroden aufgebrachte Feldstärke (E) und/oder die Aufladung (Q) der Partikel vor Eintreten in den Feldraum eingesetzt wird.

5. Anordnung zur Ablage von Partikeln über einen Metallkörper (1; 21; 55) und Messung der abgelegten Partikelmenge, bei der zwischen dem Metallkörper, als eine Elektrode, und einer diesbezüglich auf Abstand gehaltenen Gegenelektrode (5; 25; 51) ein elektrostatisches Feld (E) angelegt wird und sich in einem zwischen den Elektroden gebildeten Feldraum befindende Partikel (P) durch die Kraft des Feldes gegen den Körper (1; 21; 55) getrieben werden, mit einer Ladungsmesseinrichtung (11; $R_M$, 29; $R_M$, 47) in einem die Elektroden (1, 5; 21, 25; 55, 51) verbindenden Stromkreis, zur Messung der über dem Metallkörper abgelegten Partikelmenge, dadurch gekennzeichnet, dass der Feldraum (41) luftgefüllt ist und die Ladungsmesseinrichtung (11; $R_M$, 29; $R_M$, 47) die pro Zeiteinheit im Stromkreis fliessende Ladung während des Einbringens des Partikelstromes (P) in den luftgefüllten Feldraum (41) misst.

6. Anordnung nach Anspruch 5, dadurch gekennzeichnet, dass ein Ausgang der Ladungsmesseinrichtung auf einen Eingang einer Differenzeinheit (31, 47) geführt ist, deren zweitem Eingang eine vorzugsweise einstellbare Führungssignalquelle (33, $R_p$) zugeschaltet ist und dass der Ausgang der Differenzeinheit (31, 47) auf mindestens eine Stelleinrichtung (37, 40, 27, 63) für die Partikelablagerungsmenge pro Zeiteinheit wirkt.

7. Anordnung nach Anspruch 6, dadurch gekennzeichnet, dass die Stelleinrichtung eine steuerbare Düse (63) für die dem Feldraum zugeführte Partikelmenge und/oder eine Stelleinrichtung (27) für das elektrostatische Feld (E) und/oder eine Stelleinrichtung (40) für die elektrische Aufladung (Q) des in den Feldraum eingebrachten Partikelstromes umfasst.

8. Verwendung des Verfahrens nach einem der Ansprüche 1 bis 3 für Metallkörper im Durchlaufbetrieb.

9. Verwendung der Anordnung nach einem der Ansprüche 5 bis 7 für Metallkörper im Durchlaufbetrieb.

10. Verwendung nach einem der Ansprüche 8 oder 9 für die Schweissnahtabdeckung an Metalldosenkörpern.

## Claims

1. Process for depositing particles upon a metal body and for measuring the amount of particles deposited, whereby an electrostatic field (E) is applied between the metal body (1; 21; 55), being one of the electrodes, and a counter-electrode (5; 25; 51) kept at a distance with respect to the first electrode, and whereby particles (P) in a field area formed between the electrodes (1, 5; 21, 25; 51, 55) are driven by the force of the field against said body (1; 21; 55) and whereby the amount of particles deposited is derived from measuring a charge flowing in a current loop (3; 3, 11; $R_M$, 29; $R_M$, 47) connecting the electrodes, characterised in that a particle stream is introduced into an air-filled field area with the amount deposited per unit of time being determined by measuring the charge (q) flowing in said current loop per unit of time.

2. Process according to claim 1, characterised in that the amount of particles deposited during a preset time period is determined by integration of the charge measured.

3. Process according to claim 1 or 2, characterised in that the measuring signal is used as measured, a controlled variable in a negative feedback control loop (31, 35, 37) for negative feedback controlling the deposited amount per unit of time as controlled variable.

4. Process according to claim 3, characterised in that the control variable used in said control loop is the amount of particles (P) introduced into the field area per unit of time and/or the field strength (E) applied between the electrodes and/or the charge (Q) applied to the particles prior to entering the field area.

5. Arrangement for depositing particles upon a metal body (1; 21; 55) and measuring the amount of particles deposited, whereby an electrostatic field (E) is applied between the metal body, being an electrode, and a counter-electrode (5; 25; 51) kept at a distance with respect to the electrode, and whereby particles (P) in the field area formed between the electrodes are driven by the force of the field against said body (1; 21; 55), and comprising a charge measuring device (11; $R_M$, 29; $R_M$, 47) in a current loop connecting the electrodes (1, 5; 21, 25; 55, 51) for measuring the amount of particles deposited upon the metal body, characterised in that the field area (41) is air-filled and in that the charge-measuring device (11; $R_M$, 29; $R_M$, 47) measures the charge flowing per unit of time in the current loop during introduction of the particle stream (P) into the air-filled field area (41).

6. Arrangement according to claim 5, characterised in that an output of the charge-measuring device goes to an input of a difference unit (31, 47) the second input of which is connected to a preferably adjustable control signal source (33, $R_p$) and in that the output of the difference unit (31, 47) acts upon at least one controlling device (37, 40, 27, 63) for the amount of particles deposited per unit of time.

7. Arrangement according to claim 6, characterised in that the controlling device comprises an adjustable nozzle (63) for the amount of particles supplied to the field area and/or a regulating device (27) for the electrostatic field (E) and/or a regulating device (40) for the electrical charging (Q) of the particle stream introduced into the field area.

8. Application of the process according to one of claims 1 to 3 for coating metal bodies in a continuous operation.

9. Application of the arrangement according to one of claims 5 to 7 for coating metal bodies in a continuous operation.

10. Application according to one of claims 8 or 9 for coating weld seams on metal can bodies.

## Revendications

1. Procédé pour déposer des particules au dessus d'un corps métallique et pour mesurer la quantité de particules déposée, dans lequel on crée un champ électrostatique (E) entre le corps métallique (1; 21; 55), servant d'électrode, et une contre-électrode (5; 25; 51) qui en est maintenue à une certaine distance; et dans lequel des particules (P), qui se trouvent dans un espace qui est formé entre les électrodes (1, 5; 21, 25; 51, 55) et dans lequel existe le champ, sont entraînées, par la force du champ, en direction du corps (1; 21; 55) et dans lequel, d'une mesure d'une charge qui s'écoule dans un circuit (3; 3, 11; $R_M$, 29; $R_M$, 47) qui relie les électrodes, on déduit la quantité de particules déposée, caractérisé en ce qu'on établit un courant de particules dans un espace rempli d'air dans lequel existe le champ et en ce que l'on y saisit la quantité déposée par unité de temps par mesure de la charge (q) qui s'écoule dans le circuit par unité de temps.

2. Procédé selon la revendication 1, caractérisé en ce que l'on saisit la quantité de particules déposée pendant une période donnée par intégration de la charge mesurée.

3. Procédé selon la revendication 1 ou 2, caractérisé en ce que le signal de mesure est pris comme grandeur réglée mesurée et est introduit dans un circuit de régulation (31, 35, 37) pour régler la quantité déposée par unité de temps, en tant que grandeur réglée.

4. Procédé selon la revendication 3, caractérisé en ce que, en tant que grandeur réglante, on introduit dans le circuit de régulation la quantité de particules (P) amenée par unité de temps dans l'espace où existe le champ et/ou l'intensité du champ (E) établie entre les électrodes et/ou l'état de charge (Q) des particules avant leur introduction dans l'espace où existe le champ.

5. Dispositif pour déposer des particules sur un corps métallique (1; 21; 55) et pour mesurer la quantité de particules déposée, dans lequel on crée un champ électrostatique (E) entre le corps métallique (1; 21; 55), servant d'électrode et une contre-électrode (5; 25; 51) qui en est maintenue à une certaine distance; et dans lequel des particules (P), qui se trouvent dans un espace qui est formé entre les électrodes et dans lequel existe le champ, sont entrainées, par la force du champ, en direction du corps; comportant, dans un circuit reliant les électrodes (1, 5; 21, 25; 55, 51), un appareil de mesure de la charge (11; $R_M$, 47) pour mesurer la quantité de particules déposée sur le corps métallique, caractérisé en ce que l'espace (41) dans lequel existe le champ est rempli d'air; et en ce que l'appareil de mesure de la charge (11; $R_M$, 29; $R_M$, 47) mesure la charge qui s'écoule dans le circuit par unité de temps pendant que le flux de particules (P) est établi dans l'espace (41), rempli d'air, dans lequel existe le champ.

6. Dispositif selon la revendication 5, caractérisé en ce qu'un signal de sortie de l'appareil de mesure de la charge est amené à une entrée d'un élément soustracteur (31, 47) à la deuxième entrée duquel est reliée une source (33, $R_p$) de signaux de référence, de préférence réglable; et en ce que le signal de sortie de l'élément soustracteur (31, 47) agit sur au moins un organe (37; 40, 27, 63) de régulation de la quantité de particules déposées par unité de temps.

7. Dispositif selon la revendication 6, caractérisé en ce que l'organe de régulation est une buse (63) que l'on peut commander pour la quantité de particules amenée dans l'espace où existe le champ et/ou un organe de régulation (27) pour le champ électrostatique (E) et/ou un organe de régulation (40) pour l'état de charge électrique (Q) du flux de particules établi dans l'espace où existe le champ.

8. Emploi du procédé selon l'une des revendications 1 à 3 pour des corps métalliques en passage continu.

9. Emploi du dispositif selon l'une des revendications 5 à 7 pour des corps métalliques en passage continu.

10. Emploi selon l'une des revendications 8 ou 9 pour le revêtement des cordons de soudure sur des corps de boîtes métalliques.

0 157 003

FIG.1

FIG. 2

FIG.3

FIG. 4